Europäisches Patentamt

European Patent Office

Office européen des brevets

(19)

(11) **EP 1 372 261 A1**

(12) # EUROPEAN PATENT APPLICATION

(43) Date of publication:
**17.12.2003 Bulletin 2003/51**

(51) Int Cl.⁷: **H03G 3/30**

(21) Application number: **02254068.6**

(22) Date of filing: **12.06.2002**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **Agilent Technologies, Inc. - a Delaware corporation -**
**Palo Alto, CA 94303-0870 (US)**

(72) Inventor: **Bardsley, Richard**
**Andover, Hampshire SP10 2JQ (GB)**

(74) Representative: **Coker, David Graeme et al**
**Agilent Technologies UK Ltd,**
**Legal Dept,**
**Eskdale Road,**
**Winnersh Triangle**
**Wokingham, Berks RG41 5DZ (GB)**

(54) **Control loop apparatus, current measuring circuit apparatus and methods therefor**

(57)     In a receiver of an optical communications network, it is known to provide a reverse biased Avalanche PhotoDiode (APD). Two existing techniques for measuring a photocurrent flowing through the APD involve a current mirror located either after the APD in a circuit or before the APD in the circuit. The former location results in the introduction of noise into the circuit, whereas the latter location requires an extremely robust current mirror due to the relatively high voltage required to reverse bias the APD. The present invention permits calculation of the photocurrent $I_P$ by providing a current mirror (2) coupled to a voltage converter (6), the voltage converter (6) being coupled to an APD (8). The calculated photocurrent $I_P$ can be used to control the APD (8) and maintain the photocurrent $I_P$ at an optimum level.

Fig. 1

EP 1 372 261 A1

**Description**

The present invention relates to a control loop apparatus of the type used, for example, to maintain correct operation of a photodetector, such as an Avalanche Photodiode (APD), in a communications system. Typical examples of suitable communications systems are optical communications systems, such as a Synchronous Optical NETwork (SONET). The present invention also relates to a current measuring circuit of the type, for example, suitable for measuring a photocurrent flowing through the APD. Furthermore, the present invention also relates to respective methods of controlling a photodetector and of measuring current.

In an optical communications network, optical data signals transmitted by a transmitter unit are received by a receiver unit, the receiver unit comprising a photodetector to collect optical electromagnetic radiation constituting the optical data signals and convert the collected optical data signals to electrical data signals for processing. One known circuit for collecting the optical data signals and converting the optical data signals to the electrical data signals comprises a reverse biased APD coupled between a positive supply rail and a transimpedance amplifier.

In order for the APD to reside in an operating state within a range of operating states so as to be capable of generating a sufficiently large photocurrent in response to optical electromagnetic radiation incident upon the APD, a reverse bias voltage, for example about 70V, close to the breakdown voltage of the APD, is applied across terminals of the APD. To ensure optimum operation of the APD over temperature variations of the APD, a control loop is employed to maintain the photocurrent at an optimum level, since changes in temperature affect an optimum bias voltage of the APD. In addition to the effects of temperature, the manufacturing variances associated with APDs result in variations in the photocurrent. There is therefore a clear need to ensure that the photocurrent flowing through the APD is optimum.

To measure the photocurrent, it is known to employ a current mirror and two candidate locations exist for coupling the current mirror to the APD. A first location is between the photodiode and the transimpedance amplifier, but this location results in the introduction of unwanted noise. A second location is between the positive supply rail and the APD. However, in order to reverse bias the APD, the positive supply is set to, for example, about 70V, resulting in about 70V being applied across two transistor contacts of the current mirror, i.e. across a sensing input contact and a monitoring output contact. The provision of the current mirror at the second location is therefore difficult to implement.

According to a first aspect of the present invention, there is provided a current calculating apparatus for a detector having a state of operation requiring a high voltage to be applied thereacross, the apparatus comprising a current sensor and the detector; characterised in that the detector is coupled to an output of a voltage converter, and the current sensor is coupled to an input of the voltage converter, a current calculator being provided to calculate a current flowing through the detector in response to a measure of current generated by the current sensor.

Preferably, the voltage converter is a DC/DC converter.

Preferably, the detector is a photodetector. More preferably, the photodetector is a photodiode.

Preferably, the apparatus further comprises a transimpedance amplifier coupled to the detector.

The current sensor may be coupled to the input of the voltage converter via a current mirror, a first side of the current mirror may be coupled to the input of the voltage converter and a second side of the current mirror may be coupled to the current calculator via the current sensor.

In a first embodiment of the present invention, a control loop apparatus comprises the current calculating apparatus as set forth above in relation to the first aspect of the present invention, and further comprises a controller arranged to control the voltage converter in response to the calculated current flowing through the detector so as to control a voltage applied across the detector. It should be appreciated that the controller may comprise the current calculator .

In a second embodiment, a receiver circuit comprises the current calculating apparatus as set forth above in connection with the first aspect of the present invention, or the first embodiment.

In a third embodiment, a communications network comprises the current calculating apparatus as set forth above in connection with the first aspect of the present invention, or the first embodiment.

According to a second aspect of the present invention, there is provided a method of controlling a detector having a state of operation requiring a high voltage to be applied thereacross, the method comprising the steps of: applying a voltage across the detector; controlling the voltage in response to a measure of current, the current being measured by a current sensor; characterised in that: the voltage is applied across the detector by a voltage converter in response to the measure of the current, the current sensor measuring the current flowing into the voltage converter.

According to a third aspect of the present invention, there is provided a method of calculating a current flowing through a detector having a state of operation requiring a high voltage to be applied thereacross, the detector being coupled to an output of a voltage converter, and the method characterised by the steps of: coupling a current sensor to an input of the voltage converter; measuring a current flowing into the voltage converter; calculating the current flowing through the detector using knowledge of parameters associated with the voltage converter and the measure of the current flowing into the voltage converter.

Preferably, the parameters associated with the voltage converter are: a supply voltage, a control voltage, a constant of proportionality of a multiplication factor, the multiplication factor, and an efficiency factor of the voltage converter.

According to a fourth aspect of the present invention, there is provided a use of a voltage converter in combination with a current sensor and a controller to control a detector having a state of operation requiring a high voltage to be applied thereacross.

It is thus possible to provide a current measuring circuit apparatus and a method therefor that can calculate current flowing through the detector, thereby obviating the need to provide a current mirror or current measuring circuit downstream of the detector, or apply a high voltage across the current measuring circuit or the current mirror. Similar advantages also apply to the control loop circuit apparatus and method therefor.

At least one embodiment of the invention will now be described, by way of example only, with reference to the accompanying drawing, in which:

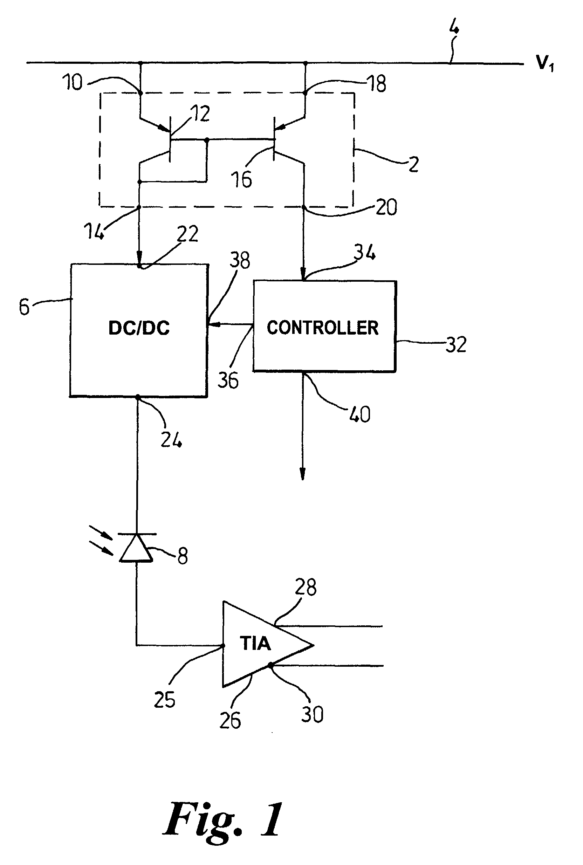

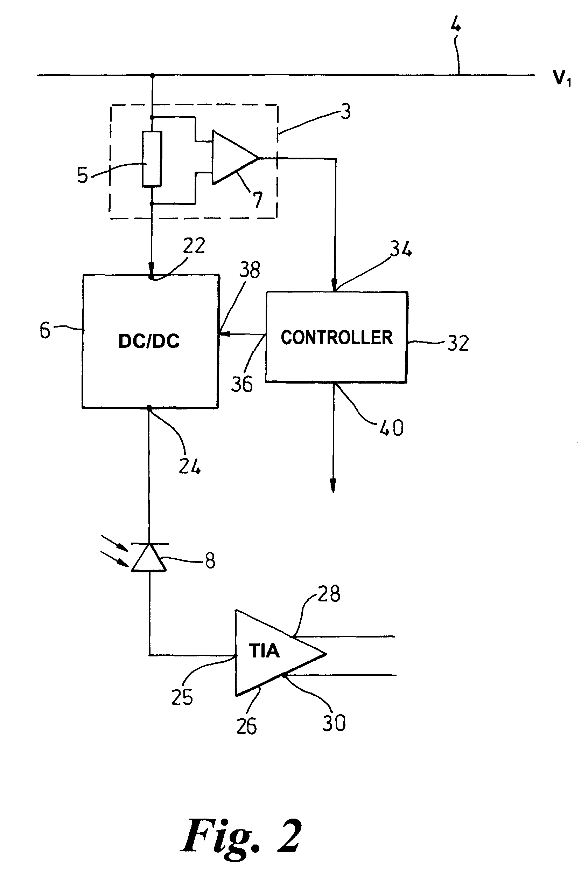

**Figure 1** is a schematic diagram of a control circuit apparatus constituting an embodiment of the invention.; and **Figure** 2 is a schematic diagram of an alternative embodiment to that of Figure 1.

In a receiver of a communications network (not shown), a current measuring circuit apparatus comprises a current mirror 2 coupled between a supply rail 4 and a voltage converter 6, for example a DC/DC converter. In this example, the supply rail 4 is set at a first voltage $V_1$ of 5V. The current measuring circuit is coupled to a detector, for example a photodetector such as an APD 8 in order to facilitate calculation of a photocurrent $I_P$ flowing through the APD 8 by measuring a current flowing into the voltage converter 6.

More specifically, a first half of the current mirror 2 comprises a first input terminal 10 coupled to the supply rail 4 and an emitter terminal of a first pnp bipolar transistor 12, a collector terminal of the first transistor 12 being coupled to a first output terminal 14 of the current mirror 2 and a base terminal of the first transistor 12. The base terminal of the first transistor 12 is also coupled to a base terminal of a second pnp bipolar transistor 16 constituting a second half of the current mirror 2. An emitter terminal of the second transistor 16 is coupled to a second input terminal 18 of the current mirror 2, the second input terminal 18 also being coupled to the supply rail 4. A collector terminal of the second transistor 16 is coupled to a second output terminal 20 of the current mirror 2.

The first output terminal 14 of the current mirror 2 is coupled to a first input terminal 22 of the voltage converter 6. An output terminal 24 of the voltage converter 6 is coupled to a cathode of the APD 8, an anode of the APD 8 being coupled to an input terminal 25 of an amplifier, for example a transimpedance amplifier 26 having a non-inverting output terminal 28 and an inverting output terminal 30.

In order to provide control of the voltage converter 6 and, hence, a voltage applied across the APD 8, a controller 32 is provided. The controller 32 can be, for example, any suitably programmed microcontroller, or an appropriately configured analogue circuit.

The second output terminal 20 of the current mirror 2 is coupled to a first input terminal 34 of the controller 32, a first output terminal 36 of the controller 32 being coupled to a second input terminal 38 of the voltage converter 6. The controller 32 also comprises a second output terminal 40 at which a calculation of the photocurrent $I_P$ is provided in order to provide an indication of optical input power, thereby enabling monitoring of the strength of the optical signal received by the APD 8. The provision of the controller 32 results in the current measuring circuit apparatus becoming a control loop circuit apparatus.

In operation, the controller 32 is set to generate a control voltage $V_c$ at the first output terminal 36 so as to cause the voltage converter 6 to generate a reverse bias voltage $V_2$ of 70V across the APD 8. Of course, the reverse bias voltage $V_2$ of 70V is an example only, and other appropriate voltage levels can be applied across the APD 8, or other detector used, depending upon the operating characteristics of that device. Indeed, it should be appreciated that a detector other than the APD 8 can be employed, the biasing voltage of the detector being greater than the voltage available from the supply rail 4.

In order for the voltage converter 6 to generate the reverse bias voltage $V_2$, a first current $I_1$ flows into the voltage converter 6 through the first transistor 12. The flow of the first current $I_1$ through the current mirror 2 causes a mirror current $I'_1$ to flow through the second transistor 16. The mirror current $I'_1$ is used in conjunction with a knowledge of the first voltage $V_1$ and the reverse bias voltage $V_2$ to calculate the photocurrent $I_P$.

The photocurrent $I_P$ generated is converted to a voltage signal by the transimpedance amplifier 26, the voltage signal being present at the non-inverting output terminal 28 and an inverted representation of the voltage signal being present at the inverting output terminal 30.

With respect to the voltage converter 6, employing the principle:

$$\text{Power IN} \quad = \quad \text{Power OUT}$$

$$I_1 V_1 \quad = \quad I_P V_2 \qquad\qquad (1)$$

Given that the voltage converter 6 has an efficiency $K_{eff}$ associated with conversation between $V_1$ and $V_2$, the power output by the voltage converter is expressed as:

$$I_P V_2 = K_{eff} I_1 V_1 \qquad (2)$$

Rearranging:

$$I_P = K_{eff} I_1 \frac{V_1}{V_2} \qquad (3)$$

Since a multiplication factor, M, is associated with the voltage converter 6, the reverse bias voltage $V_2$ can be expressed as follows:

$$V_2 = M V_1 \qquad (4)$$

Substituting this expression (4) into equation (3), the photocurrent $I_P$ is given as:

$$I_P = K_{eff} \frac{I_1}{M} \qquad (5)$$

The multiplication factor M is set by the control voltage $V_C$, the control voltage $V_C$ being proportional to the multiplication factor M. A constant of proportionality, k, therefore exists and so the relationship between $V_C$ and M is given by the following expression:

$$M = k V_C \qquad (6)$$

Hence, substituting the expression (6) for the multiplication factor, M, into equation (5) above yields an expression for calculating the photocurrent $I_P$ in terms of the mirror current $I'_1$ (=$I_1$), the efficiency $K_{eff}$, the constant of proportionality, k, and the control voltage $V_C$:

$$I_P = I'_1 \frac{K_{eff}}{k V_C} \qquad (7)$$

A relationship therefore exists between the photocurrent $I_P$ and the control voltage $V_C$ and so the controller 6 calculates the photocurrent $I_P$ from knowledge of the mirror current $I'_1$, the efficiency $K_{eff}$, the constant of proportionality k (known from the characteristics of the voltage converter 6), and the control voltage $V_C$ currently being applied to the voltage converter 6. In this example, the controller 32 is suitably programmed to employ a negative feedback control algorithm, for example a Proportional Integral Differential (PID) control algorithm, in order to maintain the photocurrent $I_P$ at an optimum level.

Consequently, if the controller 32 senses that, for the first current $I_1$ being drawn by the voltage converter 6 and the control voltage $V_C$, the voltage converter 6 starts to draw too much current, the controller 32 deduces that the reverse bias voltage $V_2$ is exceeding the breakdown voltage of the APD 8, since in this example, at the maximum power of the optical input signal, the photocurrent $I_P$ does not exceed 1 mA. In response to the reverse bias voltage $V_2$ exceeding the breakdown voltage, the controller 32 lowers the multiplication factor M by adjusting the control voltage $V_C$.

In addition to using the calculated photocurrent $I_P$, the calculated photocurrent $I_P$ is made available at the second output terminal 40 of the controller 32.

In another embodiment, the controller 32 is provided with additional input terminals (not shown) to receive additional data, for example age and temperature data. Alternatively, this information can be pre-programmed into the controller 32. The controller 32 uses the additional data to bias the control voltage $V_C$, thereby compensating for any changes in performance in the APD 8 due to changes in temperature of the APD 8 and the age of the APD 8.

In a further embodiment, current sensing is carried out external to the controller 32 by a current sensor 3 replacing the current mirror 2. In this example, a resistor 5 is coupled between the supply rail 4 and the first input terminal 22 of the voltage converter 6. Input terminals of an operational amplifier 7 are coupled across the resistor 5 and an output terminal of the operational amplifier 7 is coupled to the first input terminal 34. In this example, the controller 32 is adapted to compensate for losses incurred by the introduction of the external current sensor 3 in place of the current mirror 2.

It should be appreciated that the above examples can be implemented in the analogue or digital domains. Furthermore, although in the above examples the APD 8 is positively biased, it should be appreciated that the above examples can be easily adapted to cater for APDs, or other detectors, requiring a negative bias voltage to be applied thereacross.

**Claims**

1. A current calculating apparatus for a detector (8) having a state of operation requiring a high voltage to be applied thereacross, the apparatus comprising a current sensor (3) and the detector (8); **characterised in that** the detector (8) is coupled to an output of a voltage converter (6), and the current sensor (3) is coupled to an input of the voltage converter (6), a current calculator being provided to calculate a current ($I_P$) flowing through the detector (8) in response to a measure of current ($I_1'$) generated by the current sensor (3).

2. An apparatus as claimed in Claim 1, wherein the voltage converter (6) is a DC/DC converter.

3. An apparatus as claimed in Claim 1 or Claim 2, wherein the detector (8) is a photodetector.

4. An apparatus as claimed in Claim 3, wherein the photodetector is a photodiode.

5. An apparatus as claimed in any one of the preceding claims, wherein the current sensor (3) is coupled to the input of the voltage converter (6) via a current mirror (2), a first side of the current mirror (2) being coupled to the input of the voltage converter (6) and a second side of the current mirror (2) being coupled to the current calculator via the current sensor (3).

6. An apparatus as claimed in any one of the preceding claims, further comprising a transimpedance amplifier (26) coupled to the detector (8).

7. A control loop apparatus comprising the current calculating apparatus as claimed in any one of the preceding claims, and further comprising a controller (32) arranged to control the voltage converter (6) in response to the calculated current ($I_P$) flowing through the detector (8) so as to control a voltage ($V_2$) applied across the detector (8).

8. A receiver circuit comprising the current measuring apparatus as claimed in any one of Claims 1 to 6.

9. A communications network comprising the current measuring apparatus as claimed in any one of Claims 1 to 6.

10. A method of controlling a detector (8) having a state of operation requiring a high voltage to be applied thereacross, the method comprising the steps of:

    applying a voltage ($V_2$) across the detector (8);
    controlling the voltage ($V_2$) in response to a measure ($I_1'$) of a current ($I_1$), the current being measured by a current sensor (3); **characterised in that**:

        the voltage ($V_2$) is applied across the detector (8) by a voltage converter (6) in response to the measure ($I_1'$) of the current, the current sensor (3) measuring the current ($I_1$) flowing into the voltage converter (6).

11. A method of calculating a current flowing through a detector (8) having a state of operation requiring a high voltage to be applied thereacross, the detector (8) being coupled to an output of a voltage converter (6), and a current sensor (3) being coupled to an input of the voltage converter (6), the method **characterised by** the steps of:

    measuring a current ($I_1$) flowing into the voltage converter (6);
    calculating the current ($I_P$) flowing through the detector (8) using knowledge of parameters associated with the voltage converter (6) and the measure of the current ($I_1$) flowing into the voltage converter (6).

**12.** A method as claimed in Claim 11, wherein the parameters associated with the voltage converter (6) are: a supply voltage, a control voltage, a constant of proportionality of a multiplication factor, the multiplication factor, and an efficiency factor of the voltage converter (6).

**13.** A use of a voltage converter (6) in combination with a current sensor (3) and a controller (32) to control a detector (8) having a state of operation requiring a high voltage to be applied thereacross.

**Fig. 1**

**Fig. 2**

**European Patent Office**

## EUROPEAN SEARCH REPORT

Application Number

EP 02 25 4068

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int.Cl.7) |
| X | PATENT ABSTRACTS OF JAPAN vol. 007, no. 166 (E-188), 21 July 1983 (1983-07-21) -& JP 58 073251 A (NIPPON DENKI KK), 2 May 1983 (1983-05-02) see reference 25 in the column next to figure 3 * abstract; figure 3 * | 1-4,7-13 | H03G3/30 |
| A | EP 0 933 887 A (SUMITOMO ELECTRIC INDUSTRIES) 4 August 1999 (1999-08-04) * page 3, line 37 - page 4, line 20; figure 2 * | 5 | |
| A | US 4 540 952 A (WILLIAMS GARETH F) 10 September 1985 (1985-09-10) * column 14, line 54 - line 65; figure 29 * | 5 | |
| A | PATENT ABSTRACTS OF JAPAN vol. 017, no. 504 (E-1430), 10 September 1993 (1993-09-10) & JP 05 129857 A (SUMITOMO ELECTRIC IND LTD), 25 May 1993 (1993-05-25) * abstract * | 1 | TECHNICAL FIELDS SEARCHED (Int.Cl.7) H03G |

The present search report has been drawn up for all claims

| Place of search | Date of completion of the search | Examiner |
|---|---|---|
| THE HAGUE | 21 November 2002 | Blaas, D-L |

**ANNEX TO THE EUROPEAN SEARCH REPORT
ON EUROPEAN PATENT APPLICATION NO.**                    EP 02 25 4068

This annex lists the patent family members relating to the patent documents cited in the above-mentioned European search report.
The members are as contained in the European Patent Office EDP file on
The European Patent Office is in no way liable for these particulars which are merely given for the purpose of information.

21-11-2002

| Patent document cited in search report | | Publication date | Patent family member(s) | | Publication date |
|---|---|---|---|---|---|
| JP 58073251 | A | 02-05-1983 | JP | 1400646 C | 28-09-1987 |
| | | | JP | 62003625 B | 26-01-1987 |
| EP 0933887 | A | 04-08-1999 | EP | 0933887 A2 | 04-08-1999 |
| | | | JP | 11284445 A | 15-10-1999 |
| | | | US | 6188059 B1 | 13-02-2001 |
| US 4540952 | A | 10-09-1985 | CA | 1197295 A1 | 26-11-1985 |
| | | | DE | 3233146 A1 | 24-03-1983 |
| | | | FR | 2512609 A1 | 11-03-1983 |
| | | | GB | 2105543 A ,B | 23-03-1983 |
| | | | IT | 1152542 B | 07-01-1987 |
| | | | JP | 58053246 A | 29-03-1983 |
| | | | NL | 8203483 A | 05-04-1983 |
| | | | US | 4574249 A | 04-03-1986 |
| JP 05129857 | A | 25-05-1993 | NONE | | |

EPO FORM P0459

For more details about this annex : see Official Journal of the European Patent Office, No. 12/82